# EUROPEAN PATENT SPECIFICATION

(11) **EP 4 629 294 B1**
(45) Date of publication and mention of the grant of the patent: **28.10.2026**
(21) Application number: 24749693.8
(22) Date of filing: 31.01.2024
(51) Int. Cl.: H10F 71/00, H10F 77/30, H10F 77/164, H10F 77/1226

(54) **SOLAR CELL AND PREPARATION METHOD THEREFOR**
SOLARZELLE UND HERSTELLUNGSVERFAHREN DAFÜR
CELLULE SOLAIRE ET SON PROCÉDÉ DE PRÉPARATION

(30) Priority: 31.01.2023 CN 202310092615
(43) Date of publication of application: 08.10.2025
(73) Proprietor: Tongwei Solar (Meishan) Co., Ltd., Meishan, Sichuan 620041 (CN)
(72) Inventor: ZHOU, Fan, Meishan, Sichuan 620041 (CN); WU, Weiliang, Meishan, Sichuan 620041 (CN); WANG, Xiupeng, Meishan, Sichuan 620041 (CN); XING, Guoqiang, Meishan, Sichuan 620041 (CN)
(74) Representative: Marks & Clerk LLP
(86) International application number: PCT/CN2024/074824
(87) International publication number: WO 2024/160214

(56) References cited:
- CN-A- 114 420 786
- CN-A- 114 520 276
- CN-A- 114 520 276
- CN-A- 114 709 277
- CN-A- 114 709 277
- CN-A- 115 513 338
- CN-A- 116 093 180
- US-A1- 2015 059 839
- CHENG HAO ET AL: "Emitter formation with boron diffusion from PECVD deposited boron-doped silicon oxide for high-efficiency TOPCon solar cells", SOLAR ENERGY MATERIALS AND SOLAR CELLS, ELSEVIER SCIENCE PUBLISHERS, AMSTERDAM, NL, vol. 240, 19 March 2022 (2022-03-19), XP087019760, ISSN: 0927-0248, [retrieved on 20220319], DOI: 10.1016/J.SOLMAT.2022.111713

## Description

### TECHNICAL FIELD

The present application relates to the field of photovoltaic technology, and in particular to a solar cell, and a method for preparing the same.

### BACKGROUND

Tunnel oxide passivated contact (TOPCon) solar cell is first proposed by the Frauhofer Institute for Solar Energy Systems in Germany in 2013. The TOPCon solar cell mainly includes a front anti-reflection layer, a front passivation layer, a boron-doped silicon layer, a silicon substrate layer, a tunnel oxide layer, a phosphorus-doped polycrystalline silicon layer, and a back passivation layer stacked in sequence.

However, in conventional TOPCon solar cells, the phosphorus-doped polycrystalline silicon layer is prone to film delamination, which reduces passivation performance of the solar cells, thereby decreasing the open circuit voltage and photoelectric conversion efficiency of the solar cells. In addition, the phosphorus-doped polycrystalline silicon layer has poor resistance to silver paste corrosion. When silver electrodes are formed by screen printing with a silver paste, the phosphorus-doped polycrystalline silicon layer is prone to corrosion, which causes metal likely to pierce through the tunnel oxide layer and enter the silicon substrate layer, resulting in that the phosphorus atom doping concentration in the region where the metal is in contact with silicon in the silicon substrate layer is low, so that field passivation effect is degraded, and a large extent of metal recombination occurs in this region, leading to a loss in the open-circuit voltage of the solar cell, and in turn leading to a loss in the photoelectric conversion efficiency of the solar cell. An example of a related solar cell in the prior art is described in CHENG HAO ET AL: "Emitter formation with boron diffusion from PECVD deposited boron-doped silicon oxide for high-efficiency TOPCon solar cells", SOLAR ENERGY MATERIALS AND SOLAR CELLS, vol. 240, 19 March 2022.

### SUMMARY

An objective of the present application is to provide a solar cell and a method for preparing the same, thereby improving the open circuit voltage and the photoelectric conversion efficiency of conventional TOPCon solar cells.

In a first aspect, embodiments of the present application provide a solar cell, which includes a silicon substrate layer, a boron-doped silicon layer disposed on a front side of the silicon substrate layer, and a tunnel oxide layer and a phosphorus-doped polycrystalline silicon carbide layer sequentially disposed on a back side of the silicon substrate layer. The phosphorus-doped polycrystalline silicon carbide layer is doped with oxygen atoms.

According to the above technical solution, the phosphorus-doped polycrystalline silicon carbide layer is disposed to replace the phosphorus-doped polycrystalline silicon layer made of phosphorus-doped silicon in the conventional TOPCon solar cell, and the phosphorus-doped polycrystalline silicon carbide layer is doped with oxygen atoms, so that Si-O bonds are formed between the silicon atoms and the oxygen atoms in the phosphorus-doped polycrystalline silicon carbide layer. In the solar cell provided in the present application, the polycrystalline structure layer is mainly made of silicon carbide co-doped with phosphorus and oxygen, which is beneficial to improving the stability of the crystal structure of the phosphorus-doped polycrystalline silicon carbide layer. As such, it not only helps to avoid the film delamination phenomenon in the polycrystalline structure layer of the solar cell, thereby enhancing the passivation performance of the solar cell; but it also helps to improve the resistance of the polycrystalline structure layer to silver paste corrosion, thereby effectively reducing the metal piercing on the back side of the silicon substrate layer of the solar cell, decreasing the metal recombination in the solar cell, and further effectively improving the photoelectric conversion efficiency, open circuit voltage, and short circuit current of the solar cell.

In combination with the first aspect, in an optional embodiment of the present application, a thickness of the phosphorus-doped polycrystalline silicon carbide layer is in a range from 25 nm to 280 nm.

According to the above technical solution, the thickness of the phosphorus-doped polycrystalline silicon carbide layer is in a range from 25 nm to 280 nm, which is beneficial to improving the photoelectric conversion efficiency, open circuit voltage, and short circuit current of the solar cell.

In combination with the first aspect, in an optional embodiment of the present application, the thickness of the phosphorus-doped polycrystalline silicon carbide layer is in a range from 40 nm to 150 nm.

In combination with the first aspect, in an optional embodiment of the present application, the tunnel oxide layer is made of silicon oxide.

In combination with the first aspect, in an optional embodiment of the present application, a thickness of the tunnel oxide layer is in a range from 0.5 nm to 2 nm.

In combination with the first aspect, in an optional embodiment of the present application, the solar cell further includes a front passivation layer and a front anti-reflection layer sequentially disposed on the boron-doped silicon layer.

In combination with the first aspect, in an optional embodiment of the present application, the solar cell further includes a back passivation layer disposed on the phosphorus-doped polycrystalline silicon carbide layer, and the back passivation layer is disposed on a side of the phosphorus-doped polycrystalline silicon carbide layer away from the tunnel oxide layer.

In a second aspect, the present application provides a method for preparing the solar cell in the first aspect, which includes:
forming the boron-doped silicon layer on the front side of the silicon substrate layer;
forming the tunnel oxide layer on the back side of the silicon substrate layer;
in an atmosphere containing oxygen, sequentially forming an intrinsic amorphous silicon carbide layer and a phosphorus-doped amorphous silicon carbide layer on a surface of the tunnel oxide layer; and
annealing such that the intrinsic amorphous silicon carbide layer and the phosphorus-doped amorphous silicon carbide layer are co-converted into the phosphorus-doped polycrystalline silicon carbide layer.

According to the above technical solution, the intrinsic amorphous silicon carbide layer and the phosphorus-doped amorphous silicon carbide layer are formed in the atmosphere containing oxygen, so that Si-O bonds are formed between silicon atoms and oxygen atoms in the intrinsic amorphous silicon carbide layer and the phosphorus-doped amorphous silicon carbide layer. After annealing, the intrinsic amorphous silicon carbide layer and the phosphorus-doped amorphous silicon carbide layer can be co-converted into the phosphorus-doped polycrystalline silicon carbide layer. That is, the polycrystalline structure layer in the solar cell prepared in the present application mainly consists of silicon carbide co-doped with phosphorus and oxygen, which is beneficial to improving the stability of the crystal structure of the phosphorus-doped polycrystalline silicon carbide layer. As such, it not only helps to avoid the film delamination phenomenon in the polycrystalline structure layer of the solar cell, thereby enhancing the passivation performance of the solar cell; but it also helps to improve the resistance of the polycrystalline structure layer to silver paste corrosion, thereby effectively reducing the metal piercing on the back side of the silicon substrate layer of the solar cell, decreasing the metal recombination in the solar cell, and further effectively improving the photoelectric conversion efficiency, open circuit voltage, and short circuit current of the solar cell.

In combination with the second aspect, in an optional embodiment of the present application, the intrinsic amorphous silicon carbide layer is prepared by: forming the intrinsic amorphous silicon carbide layer on the surface of the tunnel oxide layer by vapor deposition in an atmosphere of a first mixed gas, wherein the first mixed gas includes O₂, SiH₄, CH₄, and H₂.

According to the above technical solution, the intrinsic amorphous silicon carbide layer can be prepared, and the intrinsic amorphous silicon carbide layer is doped with oxygen atoms.

Optionally, in the first mixed gas, a volume ratio of O₂, SiH₄, CH₄, and H₂ is 1: (1-10): (0.3-2): (1-10).

According to the above technical solution, O₂, SiH₄, CH₄, and H₂ are in appropriate proportions, which is conducive to the rapid preparation of the intrinsic amorphous silicon carbide layer doped with oxygen atoms.

In combination with the second aspect, in an optional embodiment of the present application, the intrinsic amorphous silicon carbide layer is formed at a temperature ranging from 350°C to 450°C.

According to the above technical solution, the intrinsic amorphous silicon carbide layer doped with oxygen atoms can be rapidly prepared.

In combination with the second aspect, in an optional embodiment of the present application, a thickness of the intrinsic amorphous silicon carbide layer is in a range from 5 nm to 80 nm.

In combination with the second aspect, in an optional embodiment of the present application, the phosphorus-doped amorphous silicon carbide layer is prepared by forming the phosphorus-doped amorphous silicon carbide layer on a surface of the intrinsic amorphous silicon carbide layer by vapor deposition in an atmosphere of a second mixed gas, wherein the second mixed gas includes O₂, SiH₄, CH₄, PH₃, and H₂.

According to the above technical solution, the phosphorus-doped amorphous silicon carbide layer can be prepared, and the phosphorus-doped amorphous silicon carbide layer is doped with oxygen atoms.

Optionally, in the second mixed gas, a volume ratio of O₂, SiH₄, CH₄, PH₃, and H₂ is 1: (1-10): (0.3-2): (1-9): (1-10).

According to the above technical solution, O₂, SiH₄, CH₄, PH₃, and H₂ are in appropriate proportions, which is conducive to the rapid preparation of the phosphorus-doped amorphous silicon carbide layer doped with oxygen atoms.

In combination with the second aspect, in an optional embodiment of the present application, the phosphorus-doped amorphous silicon carbide layer is formed at a temperature ranging from 350°C to 450°C.

According to the above technical solution, the phosphorus-doped amorphous silicon carbide layer doped with oxygen atoms can be rapidly prepared.

In combination with the second aspect, in an optional embodiment of the present application, a thickness of the phosphorus-doped amorphous silicon carbide layer is in a range from 20 nm to 200 nm.

In combination with the second aspect, in an optional embodiment of the present application, a temperature for annealing is in a range from 600°C to 1000°C.

In combination with the second aspect, in an optional embodiment of the present application, a time period for annealing is in a range from 10 mins to 60 mins.

In combination with the second aspect, in an optional embodiment of the present application, a gas atmosphere for annealing includes nitrogen gas, or oxygen gas.

According to the above technical solution, the intrinsic amorphous silicon carbide layer and the phosphorus-doped amorphous silicon carbide layer can be co-converted into the phosphorus-doped polycrystalline silicon carbide layer, which is beneficial to improving the crystal quality of the phosphorus-doped polycrystalline silicon carbide layer.

### BRIEF DESCRIPTION OF THE DRAWINGS

In order to illustrate the technical solutions in the embodiments of the present application more clearly, the drawings used in the embodiments will be described briefly. Apparently, the following drawings are merely for some embodiments of the present application, and therefore should not be considered as limiting the scope. Other related drawings can be derived based on these drawings by those of ordinary skill in the art without any creative effort.
FIG. 1 is a schematic structural view of a solar cell provided in an embodiment of the present application.
FIG. 2 is a flow chart of a preparation process of the solar cell provided in an embodiment of the present application.

Signs: 10: solar cell, 110: silicon substrate layer, 120: boron-doped silicon layer, 130: tunnel oxide layer, 140: phosphorus-doped polycrystalline silicon carbide layer, 150: front passivation layer, 160: front anti-reflection layer, 170: back passivation layer.

### DETAILED DESCRIPTION

TOPCon solar cell mainly includes a front anti-reflection layer, a front passivation layer, a boron-doped silicon layer, a silicon substrate layer, a tunnel oxide layer, a phosphorus-doped polycrystalline silicon layer, and a back passivation layer stacked in sequence.

The inventors discovered that, in conventional TOPCon solar cells, the phosphorus-doped polycrystalline silicon layer is prone to film delamination, which reduces passivation performance of the solar cells, thereby decreasing the open circuit voltage and photoelectric conversion efficiency of the solar cells.

In addition, the inventors further discovered that, in conventional TOPCon solar cells, the phosphorus-doped polycrystalline silicon layer has poor resistance to silver paste corrosion. When silver electrodes are formed by screen printing with a silver paste, the phosphorus-doped polycrystalline silicon layer is prone to corrosion, which causes metal likely to pierce through the tunnel oxide layer and enter the silicon substrate layer, resulting in that the phosphorus atom doping concentration in the region where the metal is in contact with silicon in the silicon substrate layer is low, so that field passivation effect is degraded, and a large extent of metal recombination occurs in this region, leading to a loss in the open-circuit voltage of the solar cell, and in turn leading to a loss in the photoelectric conversion efficiency of the solar cell.

Therefore, the present application provides a solar cell, which can not only prevent the polycrystalline structure layer of the TOPCon solar cell from film delamination, but also enhance the resistance of the polycrystalline structure layer of the TOPCon solar cell to silver paste corrosion, thereby improving the open circuit voltage and photoelectric conversion efficiency of the solar cell.

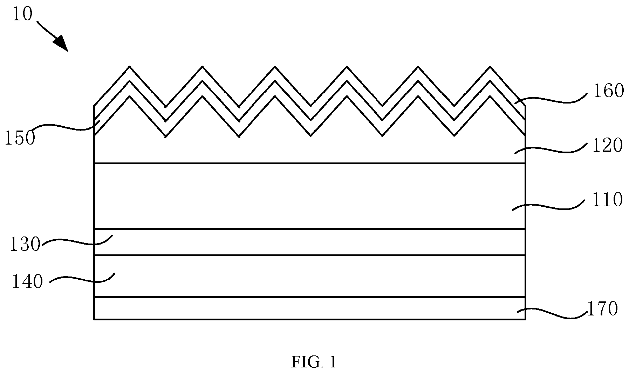

FIG. 1 is a schematic structural view of a solar cell 10 provided in an embodiment of the present application. Referring to FIG. 1, the solar cell 10 includes a silicon substrate layer 110, a boron-doped silicon layer 120 disposed on a front side of the silicon substrate layer 110, and a tunnel oxide layer 130 and a phosphorus-doped polycrystalline silicon carbide layer 140 sequentially disposed on a back side of the silicon substrate layer 110.

The phosphorus-doped polycrystalline silicon carbide layer 140 is doped with oxygen atoms.

In the solar cell 10 provided in the present application, the phosphorus-doped polycrystalline silicon carbide layer 140 is disposed to replace the phosphorus-doped polycrystalline silicon layer made of phosphorus-doped silicon in the conventional TOPCon solar cell, and the phosphorus-doped polycrystalline silicon carbide layer 140 is doped with oxygen atoms, so that Si-O bonds are formed between the silicon atoms and the oxygen atoms in the phosphorus-doped polycrystalline silicon carbide layer 140 to generate a certain amount of SiOₓ.

In the solar cell 10 provided in the present application, the phosphorus-doped polycrystalline silicon carbide layer 140 is mainly made of silicon carbide co-doped with phosphorus and oxygen, which is beneficial to improving the stability of the crystal structure of the phosphorus-doped polycrystalline silicon carbide layer 140. As such, it not only helps to avoid the film delamination phenomenon in the polycrystalline structure layer (i.e., the phosphorus-doped polycrystalline silicon carbide layer 140) of the solar cell, thereby enhancing the passivation performance of the solar cell 10; but it also helps to improve the resistance of the polycrystalline structure layer to silver paste corrosion, thereby effectively reducing the metal piercing on the back side of the silicon substrate layer of the solar cell 10, decreasing the metal recombination in the solar cell 10, and further effectively improving the photoelectric conversion efficiency, open circuit voltage, and short circuit current of the solar cell 10.

In an embodiment, the tunnel oxide layer 130 is made of silicon oxide (SiOₓ).

In an embodiment, a thickness of the tunnel oxide layer 130 is in a range from 0.5 nm to 2 nm.

As an example, the thickness of the tunnel oxide layer 130 can be 0.5 nm, 0.7 nm, 1 nm, 1.2 nm, 1.5 nm, 1.7 nm, 2 nm, etc.

In an embodiment, a thickness of the phosphorus-doped polycrystalline silicon carbide layer 140 is in a range from 25 nm to 280 nm, which is beneficial to improving the photoelectric conversion efficiency, open circuit voltage, and short circuit current of the solar cell 10. Further, the thickness of the phosphorus-doped polycrystalline silicon carbide layer 140 is in a range from 40 nm to 150 nm, which is beneficial to improving the resistance of the polycrystalline structure layer to silver paste corrosion.

As an example, the thickness of the phosphorus-doped polycrystalline silicon carbide layer 140 can be 25 nm, 50 nm, 70 nm, 100 nm, 120 nm, 150 nm, 200 nm, 250 nm, 280 nm, etc.

In an embodiment, the solar cell 10 further includes a front passivation layer 150 and a front anti-reflection layer 160 sequentially disposed on the boron-doped silicon layer 120.

In an embodiment, the front passivation layer 150 is made of aluminum oxide (AlOₓ).

In an embodiment, the front anti-reflection layer 160 is made of silicon nitride (SiNₓ).

In an embodiment, the solar cell 10 further includes a back passivation layer 170 disposed on the phosphorus-doped polycrystalline silicon carbide layer 140, and the back passivation layer 170 is disposed on a side of the phosphorus-doped polycrystalline silicon carbide layer 140 away from the tunnel oxide layer 130.

In an embodiment, the back passivation layer 170 is made of silicon nitride (SiNₓ).

In an embodiment, the solar cell 10 further includes a front electrode not shown in the figure, and a back electrode not shown in the figure. As an example, the front electrode is made of silver-aluminum, and the back electrode is made of silver.

The present application further provides a method for preparing a solar cell 10, including: forming a boron-doped silicon layer 120 on a front side of a silicon substrate layer 110; forming a tunnel oxide layer 130 on a back side of the silicon substrate layer 110; in an atmosphere containing oxygen, sequentially forming an intrinsic amorphous silicon carbide layer and a phosphorus-doped amorphous silicon carbide layer on a surface of the tunnel oxide layer 130; and annealing such that the intrinsic amorphous silicon carbide layer and the phosphorus-doped amorphous silicon carbide layer are co-converted into a phosphorus-doped polycrystalline silicon carbide layer 140.

According to the preparation method of the solar cell 10 provided in the present application, the intrinsic amorphous silicon carbide layer and the phosphorus-doped amorphous silicon carbide layer are formed in the atmosphere containing oxygen, so that Si-O bonds are formed between silicon atoms and oxygen atoms in the intrinsic amorphous silicon carbide layer and the phosphorus-doped amorphous silicon carbide layer. After annealing, the intrinsic amorphous silicon carbide layer and the phosphorus-doped amorphous silicon carbide layer can be co-converted into the phosphorus-doped polycrystalline silicon carbide layer 140. That is, the polycrystalline structure layer in the solar cell 10 prepared in the present application mainly consists of silicon carbide co-doped with phosphorus and oxygen, which is beneficial to improving the stability of the crystal structure of the phosphorus-doped polycrystalline silicon carbide layer 140. As such, it not only helps to avoid the film delamination phenomenon in the polycrystalline structure layer of the solar cell 10, thereby enhancing the passivation performance of the solar cell 10; but it also helps to improve the resistance of the polycrystalline structure layer to silver paste corrosion, thereby effectively reducing the metal piercing on the back side of the silicon substrate layer of the solar cell 10, decreasing the metal recombination in the solar cell 10, and further effectively improving the photoelectric conversion efficiency, open circuit voltage, and short circuit current of the solar cell 10.

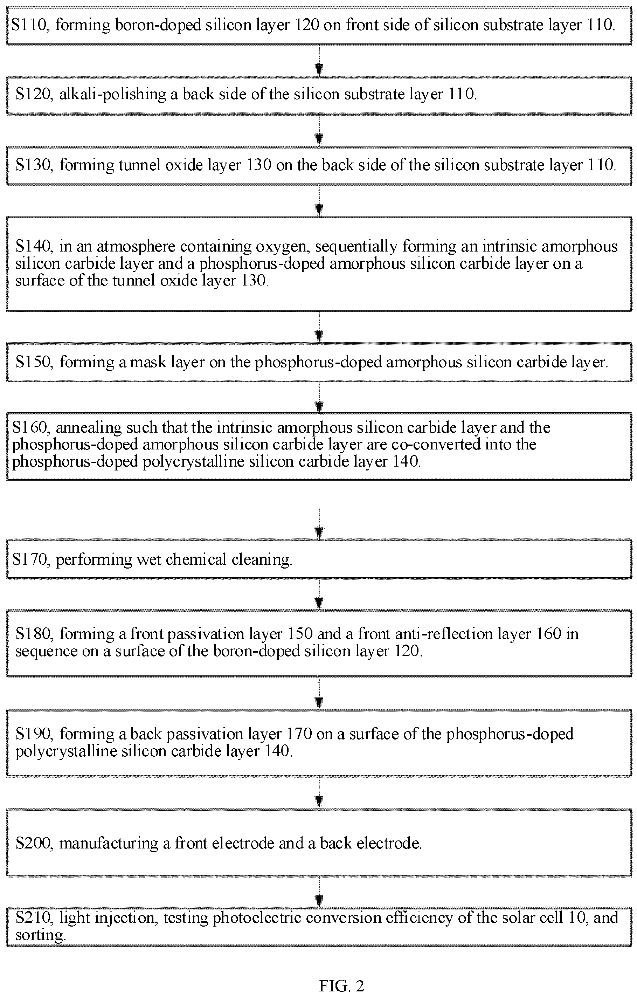

FIG. 2 is a flow chart of the preparation process of the solar cell 10 provided in an embodiment of the present application. It should be understood that, although the steps in the flow chart shown in FIG. 2 are displayed in sequence as indicated by the arrows, these steps are not necessarily performed in the order indicated by the arrows. Unless otherwise specified herein, there is no strict order restriction on the execution of these steps, and these steps can be performed in other orders. Moreover, at least a part of the steps in FIG. 2 can include multiple sub-steps or multiple stages, and these sub-steps or stages are not necessarily performed at the same time, but can be performed at different times, and the order of execution is not necessarily sequential, but can be performed in turn or alternately with other steps or at least a portion of the sub-steps or stages of other steps.

Referring to FIG. 1 and FIG. 2, the solar cell 10 is prepared by the following steps.

S110, forming a boron-doped silicon layer 120 on a front side of a silicon substrate layer 110.

In an embodiment, the silicon substrate layer 110 is a silicon wafer that has been subjected to texturing treatment. The texturing treatment can form a pyramid-shaped textured surface structure on the front side of the silicon wafer, which plays a role in reducing reflection and trapping light.

As an example, the texturing treatment includes: texturing a N-type silicon wafer with a 1 wt% alkali solution, and then cleaning the silicon wafer with a mixture of hydrogen peroxide and alkali to obtain the silicon substrate layer 110.

In an embodiment, the step of forming the boron-doped silicon layer 120 on the front side of the silicon substrate layer 110 includes: diffusing at 900°C to 1050°C in the presence of BCl₃ gas to form a p-n junction, thereby obtaining the boron-doped silicon layer 120 on the front side of the silicon substrate layer 110.

S120, alkali-polishing a back side of the silicon substrate layer 110.

In an embodiment, alkali-polishing the back side of the silicon substrate layer 110 includes removing the borosilicate glass (BSG) wrapped on the back side of the silicon substrate layer 110 due to boron diffusion by using a chained HF machine, and transferring the silicon wafer to a tank-type alkali polishing machine through a robot to remove the p-n junctions in the back side and edge of the silicon substrate layer 110.

S130, forming a tunnel oxide layer 130 on the back side of the silicon substrate layer 110.

In an embodiment, a tunnel oxide layer 130 with a thickness of 0.5 nm to 2 nm is formed on the back side of the silicon substrate layer 110 by plasma enhanced atomic layer deposition (PEALD) or plasma enhanced chemical vapor deposition (PECVD) in an atmosphere of nitrogen monoxide.

S140, in an atmosphere containing oxygen, sequentially forming an intrinsic amorphous silicon carbide layer and a phosphorus-doped amorphous silicon carbide layer on a surface of the tunnel oxide layer 130.

In an embodiment, the intrinsic amorphous silicon carbide layer is prepared by: forming the intrinsic amorphous silicon carbide layer on a surface of the tunnel oxide layer 130 by vapor deposition in an atmosphere of a first mixed gas, wherein the first mixed gas includes O₂, SiH₄, CH₄, and H₂.

According to the above preparation method, the intrinsic amorphous silicon carbide layer can be prepared, and the intrinsic amorphous silicon carbide layer is doped with oxygen atoms.

Furthermore, in the first mixed gas, a volume ratio of O₂, SiH₄, CH₄, and H₂ is 1: (1-10): (0.3-2): (1-10). Under the above volume ratio condition, O₂, SiH₄, CH₄, and H₂ are in appropriate proportions, which is conducive to the rapid preparation of the intrinsic amorphous silicon carbide layer doped with oxygen atoms.

As an example, in the first mixed gas, the volume ratio of O₂, SiH₄, CH₄, and H₂ can be 1:5:0.5:5, 1:7:1:7, 1:10:1:10, etc.

Furthermore, the intrinsic amorphous silicon carbide layer is formed at a temperature ranging from 350°C to 450°C. Under the above temperature condition, the intrinsic amorphous silicon carbide layer doped with oxygen atoms can be rapidly prepared.

As an example, the intrinsic amorphous silicon carbide layer can be formed by low pressure chemical vapor deposition (LPCVD) or plasma enhanced chemical vapor deposition (PECVD). In the present application, the intrinsic amorphous silicon carbide layer is formed by PECVD, which is beneficial to reducing the wrap-around layer, and improving the appearance and yield of the solar cell 10.

As an example, a thickness of the formed intrinsic amorphous silicon carbide layer is in a range from 5 nm to 80 nm.

In the present application, the phosphorus-doped amorphous silicon carbide layer is prepared by: forming the phosphorus-doped amorphous silicon carbide layer on a surface of the intrinsic amorphous silicon carbide layer by vapor deposition in an atmosphere of a second mixed gas, wherein the second mixed gas includes O₂, SiH₄, CH₄, PH₃, and H₂.

According to above preparation method, the phosphorus-doped amorphous silicon carbide layer can be prepared, and the phosphorus-doped amorphous silicon carbide layer is doped with oxygen atoms.

Furthermore, in the second mixed gas, a volume ratio of O₂, SiH₄, CH₄, PH₃, and H₂ is 1: (1-10): (0.3-2): (1-9): (1-10). Under the above volume ratio condition, O₂, SiH₄, CH₄, PH₃, and H₂ are in appropriate proportions, which is conducive to the rapid preparation of the phosphorus-doped amorphous silicon carbide layer doped with oxygen atoms.

As an example, in the second mixed gas, the volume ratio of O₂, SiH₄, CH₄, PH₃, and Hz can be 1:5:1:4:5, 1:7:1:5.6:7, 1:10:1:8:10, etc.

Furthermore, the phosphorus-doped amorphous silicon carbide layer is formed at a temperature ranging from 350°C to 450°C. Under the above temperature condition, the phosphorus-doped amorphous silicon carbide layer doped with oxygen atoms can be rapidly prepared.

As an example, the phosphorus-doped amorphous silicon carbide layer can be formed by low-pressure chemical vapor deposition (LPCVD) or plasma enhanced chemical vapor deposition (PECVD). In the present application, the phosphorus-doped amorphous silicon carbide layer is formed by PECVD, which is beneficial to reducing the wrap-around layer, and improving the appearance and yield of the solar cell 10.

As an example, a thickness of the formed phosphorus-doped amorphous silicon carbide layer is in a range from 20 nm to 200 nm.

S150, forming a mask layer on a surface of the phosphorus-doped amorphous silicon carbide layer.

Forming the mask layer on the surface of the phosphorus-doped amorphous silicon carbide layer is beneficial to protecting the polycrystalline structure layer (i.e., the phosphorus-doped polycrystalline silicon carbide layer 140) on the back side of the silicon substrate layer 110 from being etched and damaged during subsequent wet chemical cleaning, thereby ensuring the photoelectric conversion efficiency of the solar cell 10 finally manufactured.

As an example, forming the mask layer on the surface of the phosphorus-doped amorphous silicon carbide layer includes: introducing a mixed gas of SiH₄ and N₂O, and depositing a mask layer made of SiOₓ and having a thickness of 10 nm to 50 nm at 350°C to 450°C through PECVD process.

S160, annealing such that the intrinsic amorphous silicon carbide layer and the phosphorus-doped amorphous silicon carbide layer are co-converted into the phosphorus-doped polycrystalline silicon carbide layer 140.

In an embodiment, a temperature for annealing is in a range from 600°C to 1000°C. In an embodiment, a time period for annealing is in a range from 10 mins to 60 mins. Under the above annealing conditions, the intrinsic amorphous silicon carbide layer and the phosphorus-doped amorphous silicon carbide layer can be co-converted into the phosphorus-doped polycrystalline silicon carbide layer 140, which is beneficial to improving the crystal quality of the phosphorus-doped polycrystalline silicon carbide layer 140. In addition, phosphorus atoms can form covalent bonds with oxygen-doped amorphous silicon carbide, thereby providing electrons to form a field passivation structure.

As an example, the temperature for annealing can be 600°C, 650°C, 700°C, 800°C, 900°C, 1000°C, etc. The time period for annealing can be 10 mins, 15 mins, 20 mins, 30 mins, 45 mins, 50 mins, 60 min, etc.

In the present application, a gas atmosphere for annealing can include, but is not limited to, nitrogen gas, oxygen gas, etc.

S170, performing wet chemical cleaning.

In an embodiment, the wet chemical cleaning includes first cleaning with chained hydrofluoric acid (HF) to remove the oxide layer wrapped on the front side of the silicon substrate layer 110 in step S130 and the polycrystalline structure layer formed on the front side of the silicon substrate layer 110 during annealing in step S160; and then transferring the silicon wafer to a tank containing an alkaline solution to remove the silicon carbide wrap-around layer on the front side of the silicon substrate layer 110 and the mask layer on the back side of the silicon substrate layer 110.

S180, forming a front passivation layer 150 and a front anti-reflection layer 160 in sequence on a surface of the boron-doped silicon layer 120.

In an embodiment, an aluminum oxide (AlOₓ) film is deposited on the surface of the boron-doped silicon layer 120 by atomic layer deposition (ALD) to form the front passivation layer 150. A silicon nitride (SiNₓ) film is deposited on the front passivation layer 150 by PECVD to form the front anti-reflection layer 160.

S190, forming a back passivation layer 170 on a surface of the phosphorus-doped polycrystalline silicon carbide layer 140.

In an embodiment, a silicon nitride (SiNₓ) film is deposited on the surface of the phosphorus-doped polycrystalline silicon carbide layer 140 by PECVD to form the back passivation layer 170.

S200, manufacturing a front electrode and a back electrode.

In an embodiment, a silver paste is coated on the front side and the back side of the solar cell 10 by screen printing to prepare the front electrode and the back electrode.

In an embodiment, the front electrode is made of silver-aluminum. In an embodiment, the back electrode is made of silver.

S210, light injection, testing photoelectric conversion efficiency of the solar cell 10, and sorting.

As an example, the light injection is performed at a temperature of 700°C.

The technical solutions in the embodiments of the present application will now be described clearly and comprehensively in order to make the objectives, technical solutions, and advantages of the embodiments of the present application more clear. If the specific conditions are not specified in the embodiments, they are carried out according to the conventional conditions or the conditions recommended by the manufacturer. If the manufacturer is not specified for the reagents or instruments used, they are all conventional products that can be purchased commercially.

### Example

This example provides a method for preparing a solar cell, including the following steps.
(1) Texturing: A N-type silicon wafer was textured with a 1 wt% sodium hydroxide solution, and then the silicon wafer was cleaned with hydrogen peroxide and sodium hydroxide solution to obtain a silicon substrate layer.
(2) Boron diffusion: The silicon substrate layer was placed in a boron diffusion furnace, and p-n junctions was formed by BCl₃ gas diffusion at 1000°C, resulting in a boron-doped silicon layer on the front side of the silicon substrate layer.
(3) Alkali polishing: The borosilicate glass (BSG) wrapped on the back side of the silicon substrate layer due to boron diffusion was removed by using a chained HF machine, and then the silicon wafer was transferred to a tank-type alkali polishing machine through a robot to remove the p-n junctions in the back side and edge of the silicon substrate layer.
(4) Formation of a tunnel oxide layer: In a PECVD device, at 400°C, nitric oxide gas was introduced, and a tunnel oxide layer with a thickness of 1 nm was formed on the back side of the silicon substrate layer.
(5) Formation of an intrinsic amorphous silicon carbide layer: In a PECVD device, at 400°C, O₂, SiH₄, CH₄, and H₂ in a volume ratio of 1:10:1:10 were introduced, and an intrinsic amorphous silicon carbide layer with a thickness of 30 nm was formed on the surface of the tunnel oxide layer.
(6) Formation of a phosphorus-doped amorphous silicon carbide layer: In a PECVD device, at 400°C, O₂, SiH₄, CH₄, PH₃, and H₂ in a volume ratio of 1:10:1:8:10 were introduced, and a phosphorus-doped amorphous silicon carbide layer with a thickness of 150 nm was formed on the surface of the intrinsic amorphous silicon carbide layer.
(7) Formation of a mask layer: In a PECVD device, at 400°C, SiH₄ and N₂O with a volume ratio of 1:5 were introduced, and a mask layer (SiOₓ) with a thickness of 20 nm was formed on the surface of the phosphorus-doped amorphous silicon carbide layer.
(8) Annealing: In a gas atmosphere of nitrogen gas, the silicon wafer was annealed in a tubular annealing furnace at a temperature of 900°C for 20 minutes.
(9) RCA cleaning: First, the silicon wafer was washed with chained hydrofluoric acid (HF) to remove the oxide layer wrapped on the front side of the silicon substrate layer in step (4) and the polycrystalline structure layer formed on the front side of the silicon substrate layer during annealing in step (8). Then, the silicon wafer was transferred to a tank containing an alkaline solution to remove the silicon carbide wrap-around layer on the front side of the silicon substrate layer and the mask layer on the back side of the silicon substrate layer.
(10) Formation of a front passivation layer and a front anti-reflection layer: An aluminum oxide (AlOₓ) film was deposited on the surface of the boron-doped silicon layer by atomic layer deposition (ALD) to form a front passivation layer. A silicon nitride (SiNₓ) film was deposited on the front passivation layer by PECVD to form a front anti-reflection layer.
(11) Formation of a back passivation layer: A silicon nitride (SiNₓ) film was deposited on the surface of the phosphorus-doped polycrystalline silicon carbide layer by PECVD to form a back passivation layer.
(12) Making a front electrode and a back electrode: A silver paste was coated on the back side of the solar cell to prepare the back electrode, and a silver-aluminum paste was coated on the front side of the solar cell to prepare the front electrode.
(13) Light injection treatment was performed at 700°C.

### Comparative Example 1

This comparative example provides a method for preparing a solar cell. The comparative example differed from the above Example in step (5) and step (6).

Step (5): In a PECVD device, at 400°C, SiH₄, CH₄, and H₂ in a volume ratio of 10:1:10 were introduced, and an intrinsic amorphous silicon carbide layer with a thickness of 30 nm was formed on the surface of the tunnel oxide layer.

Step (6) Formation of a phosphorus-doped amorphous silicon carbide layer: In a PECVD device, at 400°C, SiH₄, CH₄, PH₃, and H₂ in a volume ratio of 10:1:8:10 were introduced, and a phosphorus-doped amorphous silicon carbide layer with a thickness of 150 nm was formed on the surface of the intrinsic amorphous silicon carbide layer.

### Comparative Example 2

This comparative example provides a method for preparing a solar cell. The comparative example differed from the above Example in step (5) and step (6).

Step (5): In a PECVD device, at 400°C, O₂, SiH₄, and H₂ in a volume ratio of 1:10:10 were introduced, and an intrinsic amorphous silicon layer with a thickness of 30 nm was formed on the surface of the tunnel oxide layer.

Step (6) Formation of a phosphorus-doped amorphous silicon layer: In a PECVD device, at 400°C, O₂, SiH₄, PH₃, and H₂ in a volume ratio of 1:10:8:10 were introduced, and a phosphorus-doped amorphous silicon layer with a thickness of 150 nm was formed on the surface of the intrinsic amorphous silicon layer.

### Comparative Example 3

This comparative example provides a method for preparing a solar cell. The comparative example differed from the above Example in step (5) and step (6).

Step (5): In a PECVD device, at 400°C, SiH₄ and H₂ in a volume ratio of 1:1 were introduced, and an intrinsic amorphous silicon layer with a thickness of 30 nm was formed on the surface of the tunnel oxide layer.

Step (6) Formation of a phosphorus-doped amorphous silicon layer: In a PECVD device, at 400°C, SiH₄, PH₃, and Hz in a volume ratio of 10:8: 10 were introduced, and a phosphorus-doped amorphous silicon layer with a thickness of 150 nm was formed on the surface of the intrinsic amorphous silicon layer.

### Experimental Example 1

The solar cells prepared in Example and Comparative Examples 1 to 3 were subjected to performance tests. The results are shown in Table 1.

The test was performed by testing open circuit voltage, short circuit current, and photoelectric conversion efficiency of the solar cells by using the halm online I-V test system under conditions of 25°C, AM1.5, and 1 standard sun.

**Table 1**

| | Open circuit voltage (V) | Short circuit current (mA/cm²) | Fill Factor (%) | Photoelectric conversion efficiency (%) |
|---|---|---|---|---|
| Example | 0.7185 | 41.52 | 83.90 | 25.03 |
| Comparative Example 1 | 0.7176 | 41.47 | 83.85 | 24.95 |
| Comparative Example 2 | 0.7175 | 41.44 | 83.84 | 24.93 |
| Comparative Example 3 | 0.7163 | 41.40 | 83.80 | 24.85 |

It can be seen from Table 1 that, in the above Example, a phosphorus-doped polycrystalline silicon carbide layer which is doped with oxygen atoms, is formed to replace the phosphorus-doped polycrystalline silicon layer, so that the short-circuit current, open-circuit voltage, etc. of the prepared solar cell are greatly improved.

In summary, compared with Comparative Examples 1 to 3, for the solar cell in Example, the photoelectric conversion efficiency can be effectively improved to be more than 25.0%, the open circuit voltage is increased by 2 mV, and the short circuit current is increased by 0.12 mA/cm².

The embodiments described above are part of embodiments of the present application, rather than all of the embodiments. The detailed description of the embodiments of the present application is not intended to limit the protection scope of the present application, but merely represents the selected embodiments of the present application.

## Claims

1. A solar cell, comprising:
a silicon substrate layer;
a boron-doped silicon layer disposed on a front side of the silicon substrate layer;
a tunnel oxide layer and a phosphorus-doped polycrystalline silicon carbide layer sequentially disposed on a back side of the silicon substrate layer;
**characterised in that** the phosphorus-doped polycrystalline silicon carbide layer is doped with oxygen atoms.

2. The solar cell according to claim 1, wherein a thickness of the phosphorus-doped polycrystalline silicon carbide layer is in a range from 25 nm to 280 nm,
optionally, the thickness of the phosphorus-doped polycrystalline silicon carbide layer is in a range from 40 nm to 150 nm.

3. The solar cell according to claim 1 or 2, wherein the tunnel oxide layer is made of silicon oxide.

4. The solar cell according to any one of claims 1 to 3, wherein a thickness of the tunnel oxide layer is in a range from 0.5 nm to 2 nm.

5. The solar cell according to any one of claims 1 to 4, wherein the solar cell further comprises a front passivation layer and a front anti-reflection layer sequentially disposed on the boron-doped silicon layer.

6. The solar cell according to any one of claims 1 to 5, wherein the solar cell further comprises a back passivation layer disposed on the phosphorus-doped polycrystalline silicon carbide layer, and the back passivation layer is disposed on a side of the phosphorus-doped polycrystalline silicon carbide layer away from the tunnel oxide layer.

7. A method for preparing the solar cell according to any one of claims 1 to 6, comprising:
forming the boron-doped silicon layer on the front side of the silicon substrate layer;
forming the tunnel oxide layer on the back side of the silicon substrate layer;
in an atmosphere containing oxygen, sequentially forming an intrinsic amorphous silicon carbide layer and a phosphorus-doped amorphous silicon carbide layer on a surface of the tunnel oxide layer; and
annealing such that the intrinsic amorphous silicon carbide layer and the phosphorus-doped amorphous silicon carbide layer are co-converted into the phosphorus-doped polycrystalline silicon carbide layer.

8. The method for preparing the solar cell according to claim 7, wherein the intrinsic amorphous silicon carbide layer is prepared by: forming the intrinsic amorphous silicon carbide layer on the surface of the tunnel oxide layer by vapor deposition in an atmosphere of a first mixed gas, wherein the first mixed gas comprises O₂, SiH₄, CH₄, and H₂, optionally, in the first mixed gas, a volume ratio of O₂, SiH₄, CH₄, and H₂ is 1: (1-10): (0.3-2): (1-10).

9. The method for preparing the solar cell according to claim 8, wherein the intrinsic amorphous silicon carbide layer is formed at a temperature ranging from 350°C to 450°C.

10. The method for preparing the solar cell according to claim 8 or 9, wherein a thickness of the intrinsic amorphous silicon carbide layer is in a range from 5 nm to 80 nm.

11. The method for preparing the solar cell according to any one of claims 8 to 10, wherein the phosphorus-doped amorphous silicon carbide layer is prepared by forming the phosphorus-doped amorphous silicon carbide layer on a surface of the intrinsic amorphous silicon carbide layer by vapor deposition in an atmosphere of a second mixed gas, wherein the second mixed gas comprises O₂, SiH₄, CH₄, PH₃, and H₂,
optionally, in the second mixed gas, a volume ratio of O₂, SiH₄, CH₄, PH₃, and H₂ is 1: (1-10): (0.3-2): (1-9): (1-10).

12. The method for preparing the solar cell according to claim 11, wherein the phosphorus-doped amorphous silicon carbide layer is formed at a temperature ranging from 350°C to 450°C.

13. The method for preparing the solar cell according to claim 11 or 12, wherein a thickness of the phosphorus-doped amorphous silicon carbide layer is in a range from 20 nm to 200 nm.

14. The method for preparing the solar cell according to any one of claims 7 to 13, wherein a temperature for annealing is in a range from 600°C to 1000°C,
optionally, a time period for annealing is in a range from 10 mins to 60 mins.

15. The method for preparing the solar cell according to any one of claims 7 to 14, wherein a gas atmosphere for annealing comprises nitrogen gas, or oxygen gas.

## Patentansprüche

1. Solarzelle, umfassend:
eine Siliziumsubstratschicht;
eine Bor-dotierte Siliziumschicht, die auf einer Vorderseite der Siliziumsubstratschicht angeordnet ist;
eine Tunneloxidschicht und eine Phosphor-dotierte polykristalline Siliziumcarbidschicht, die nacheinander auf einer Rückseite der Siliziumsubstratschicht angeordnet sind;
**dadurch gekennzeichnet, dass**
die Phosphor-dotierte polykristalline Siliziumcarbidschicht mit Sauerstoffatomen dotiert ist.

2. Solarzelle nach Anspruch 1, wobei eine Dicke der Phosphor-dotierten polykristallinen Siliziumcarbidschicht im Bereich von 25 nm bis 280 nm liegt,
wobei optional die Dicke der Phosphor-dotierten polykristallinen Siliziumcarbidschicht im Bereich von 40 nm bis 150 nm liegt.

3. Solarzelle nach Anspruch 1 oder 2, wobei die Tunneloxidschicht aus Siliziumdioxid hergestellt ist.

4. Solarzelle nach einem der Ansprüche 1 bis 3, wobei eine Dicke der Tunneloxidschicht im Bereich von 0,5 nm bis 2 nm liegt.

5. Solarzelle nach einem der Ansprüche 1 bis 4, wobei die Solarzelle weiter eine vordere Passivierungsschicht und eine vordere Antireflexionsschicht umfasst, die nacheinander auf der Bor-dotierten Siliziumschicht angeordnet sind.

6. Solarzelle nach einem der Ansprüche 1 bis 5, wobei die Solarzelle weiter eine auf der Phosphor-dotierten polykristallinen Siliziumcarbidschicht angeordnete Rückseitenpassivierungsschicht umfasst, und die Rückseitenpassivierungsschicht auf einer Seite der Phosphor-dotierten polykristallinen Siliziumcarbidschicht angeordnet ist, die von der Tunneloxidschicht abgewandt ist.

7. Verfahren zum Herstellen der Solarzelle nach einem der Ansprüche 1 bis 6, umfassend:
Bilden der Bor-dotierten Siliziumschicht auf der Vorderseite der Siliziumsubstratschicht;
Bilden der Tunneloxidschicht auf der Rückseite der Siliziumsubstratschicht;
in einer sauerstoffhaltigen Atmosphäre aufeinanderfolgendes Bilden einer intrinsischen amorphen Siliziumcarbidschicht und einer Phosphor-dotierten amorphen Siliziumcarbidschicht auf einer Oberfläche der Tunneloxidschicht; und
Tempern, sodass die intrinsische amorphe Siliziumcarbidschicht und die Phosphor-dotierte amorphe Siliziumcarbidschicht gemeinsam in die Phosphor-dotierte polykristalline Siliziumcarbidschicht umgewandelt werden.

8. Verfahren zum Herstellen der Solarzelle nach Anspruch 7, wobei die intrinsische amorphe Siliziumcarbidschicht hergestellt wird durch: Bilden der intrinsischen amorphen Siliziumcarbidschicht auf der Oberfläche der Tunneloxidschicht durch Dampfabscheidung in einer Atmosphäre eines ersten Mischgases, wobei das erste Mischgas O₂, SiH₄, CH₄, und H₂ umfasst,
wobei optional im ersten Mischgas ein Volumenverhältnis von O₂, SiH₄, CH₄, und H₂ 1 : (1-10) : (0,3-2) : (1-10) beträgt.

9. Verfahren zum Herstellen der Solarzelle nach Anspruch 8, wobei die intrinsische amorphe Siliziumcarbidschicht bei einer Temperatur im Bereich von 350 °C bis 450 °C gebildet wird.

10. Verfahren zum Herstellen der Solarzelle nach Anspruch 8 oder 9, wobei eine Dicke der intrinsischen amorphen Siliziumcarbidschicht im Bereich von 5 nm bis 80 nm liegt.

11. Verfahren zum Herstellen der Solarzelle nach einem der Ansprüche 8 bis 10, wobei die Phosphor-dotierte amorphe Siliziumcarbidschicht durch Bilden der Phosphor-dotierten amorphen Siliziumcarbidschicht auf einer Oberfläche der intrinsischen amorphen Siliziumcarbidschicht durch Dampfabscheidung in einer Atmosphäre eines zweiten Mischgases hergestellt wird, wobei das zweite Mischgas O₂, SiH₄, CH₄, PH₃, und H₂ umfasst,
wobei optional in dem zweiten Mischgas ein Volumenverhältnis von O₂, SiH₄, CH₄, PH₃, und H₂ 1 : (1-10) : (0,3-2) : (1-9) : (1-10) beträgt.

12. Verfahren zum Herstellen der Solarzelle nach Anspruch 11, wobei die Phosphor-dotierte amorphe Siliziumcarbidschicht bei einer Temperatur im Bereich von 350 °C bis 450 °C gebildet wird.

13. Verfahren zum Herstellen der Solarzelle nach Anspruch 11 oder 12, wobei eine Dicke der Phosphor-dotierten amorphen Siliziumcarbidschicht im Bereich von 20 nm bis 200 nm liegt.

14. Verfahren zum Herstellen der Solarzelle nach einem der Ansprüche 7 bis 13, wobei eine Temperatur zum Tempern im Bereich von 600 °C bis 1000 °C liegt,
wobei optional eine Zeitspanne zum Tempern im Bereich von 10 bis 60 Minuten liegt.

15. Verfahren zum Herstellen der Solarzelle nach einem der Ansprüche 7 bis 14, wobei eine Gasatmosphäre zum Tempern Stickstoffgas oder Sauerstoffgas umfasst.

## Revendications

1. Cellule solaire, comprenant :
une couche de substrat en silicium ;
une couche de silicium dopée au bore disposée sur une face avant de la couche de substrat en silicium ;
une couche d'oxyde tunnel et une couche de carbure de silicium polycristallin dopée au phosphore disposées séquentiellement sur une face arrière de la couche de substrat en silicium ;
**caractérisée en ce que**
la couche de carbure de silicium polycristallin dopée au phosphore est dopée avec des atomes d'oxygène.

2. Cellule solaire selon la revendication 1, dans laquelle une épaisseur de la couche de carbure de silicium polycristallin dopée au phosphore est dans une plage de 25 nm à 280 nm,
éventuellement, l'épaisseur de la couche de carbure de silicium polycristallin dopée au phosphore est dans une plage de 40 nm à 150 nm.

3. Cellule solaire selon la revendication 1 ou 2, dans laquelle la couche d'oxyde tunnel est constituée d'oxyde de silicium.

4. Cellule solaire selon l'une quelconque des revendications 1 à 3, dans laquelle une épaisseur de la couche d'oxyde tunnel est dans une plage de 0,5 nm à 2 nm.

5. Cellule solaire selon l'une quelconque des revendications 1 à 4, dans laquelle la cellule solaire comprend en outre une couche de passivation avant et une couche anti-reflet avant disposées séquentiellement sur la couche de silicium dopée au bore.

6. Cellule solaire selon l'une quelconque des revendications 1 à 5, dans laquelle la cellule solaire comprend en outre une couche de passivation arrière disposée sur la couche de carbure de silicium polycristallin dopée au phosphore, et la couche de passivation arrière est disposée sur une face de la couche de carbure de silicium polycristallin dopée au phosphore, à l'opposé de la couche d'oxyde tunnel.

7. Procédé de préparation de la cellule solaire selon l'une quelconque des revendications 1 à 6, comprenant :
la formation de la couche de silicium dopée au bore sur la face avant de la couche de substrat en silicium ;
la formation de la couche d'oxyde tunnel sur la face arrière de la couche de substrat en silicium ;
dans une atmosphère contenant de l'oxygène, la formation successivement d'une couche de carbure de silicium amorphe intrinsèque et d'une couche de carbure de silicium amorphe dopée au phosphore sur une surface de la couche d'oxyde tunnel ; et
le recuit de sorte que la couche de carbure de silicium amorphe intrinsèque et la couche de carbure de silicium amorphe dopée au phosphore soient co-converties en couche de carbure de silicium polycristallin dopée au phosphore.

8. Procédé de préparation de la cellule solaire selon la revendication 7, dans lequel la couche de carbure de silicium amorphe intrinsèque est préparée par : la formation de la couche de carbure de silicium amorphe intrinsèque sur la surface de la couche d'oxyde tunnel par dépôt en phase vapeur dans une atmosphère d'un premier mélange gazeux, ledit premier mélange gazeux comprenant O₂, SiH₄, CH₄, et H₂,
éventuellement, dans le premier mélange gazeux, un rapport volumique de O₂, SiH₄, CH₄, et H₂ est 1: (1-10): (0,3-2): (1-10).

9. Procédé de préparation de la cellule solaire selon la revendication 8, dans lequel la couche de carbure de silicium amorphe intrinsèque est formée à une température dans une plage de 350 °C à 450 °C.

10. Procédé de préparation de la cellule solaire selon la revendication 8 ou 9, dans lequel une épaisseur de la couche de carbure de silicium amorphe intrinsèque est dans une plage de 5 nm à 80 nm.

11. Procédé de préparation de la cellule solaire selon l'une quelconque des revendications 8 à 10, dans lequel la couche de carbure de silicium amorphe dopée au phosphore est préparée en formant la couche de carbure de silicium amorphe dopée au phosphore sur une surface de la couche de carbure de silicium amorphe intrinsèque par dépôt en phase vapeur dans une atmosphère d'un deuxième mélange gazeux, ledit deuxième mélange gazeux comprenant O₂, SiH₄, CH₄, PH₃, et H₂,
éventuellement, dans le deuxième mélange gazeux, un rapport volumique de O₂, SiH₄, CH₄, PH₃, et H₂ est 1: (1-10): (0,3-2): (1-9): (1-10).

12. Procédé de préparation de la cellule solaire selon la revendication 11, dans lequel la couche de carbure de silicium amorphe dopée au phosphore est formée à une température dans une plage de 350 °C à 450 °C.

13. Procédé de préparation de la cellule solaire selon la revendication 11 ou 12, dans lequel l'épaisseur de la couche de carbure de silicium amorphe dopée au phosphore est dans une plage de 20 nm à 200 nm.

14. Procédé de préparation de la cellule solaire selon l'une quelconque des revendications 7 à 13, dans lequel une température de recuit est dans une plage de 600 °C à 1000 °C,
éventuellement, une durée de recuit est dans une plage de 10 minutes à 60 minutes.

15. Procédé de préparation de la cellule solaire selon l'une quelconque des revendications 7 à 14, dans lequel une atmosphère gazeuse pour le recuit comprend de l'azote gazeux ou de l'oxygène gazeux.
